# EUROPÄISCHE PATENTSCHRIFT

(11) **EP 0 909 018 B1**
(45) Veröffentlichungstag und Bekanntmachung des Hinweises auf die Patenterteilung: **02.01.2002**
(21) Anmeldenummer: 98116622.6
(22) Anmeldetag: 02.09.1998
(51) Int. Cl.: H03B 5/12

(54) **Oszillator**
Oscillator
Oscillateur

(30) Priorität: 11.09.1997 DE 19740002
(43) Veröffentlichungstag der Anmeldung: 14.04.1999
(73) Patentinhaber: Infineon Technologies AG, 81669 München (DE)
(72) Erfinder: Fenk, Josef, 85386 Eching (DE); Weber, Stefan, 81739 München (DE); Kolb, Bernd, 82008 Unterhaching (DE); Zannoth, Markus, 85221 Riemerling (DE)
(74) Vertreter: Zedlitz, Peter, Dipl.-Inf.

(56) Entgegenhaltungen:
- EP-A- 0 785 616
- DE-B- 1 267 728
- US-A- 5 483 207
- MARCH IAN: "A Wide Range VCO" NEW ELECTRONICS, Bd. 15, Nr. 24, Dezember 1982, Seite 19 XP002088935 Harpenden (GB)
- NGUYEN N M ET AL: "A 1.8-GHZ MONOLITHIC LC VOLTAGE-CONTROLLED OSCILLATOR" IEEE JOURNAL OF SOLID-STATE CIRCUITS, Bd. 27, Nr. 3, 1. März 1992, Seiten 444-450, XP000295903

## Beschreibung

Die Erfindung betrifft einen Oszillator der beispielsweise im Mobilfunkbereich verwendbar ist. Der Oszillator, welcher Bestandteil eines spannungsgesteuerten Oszillators sein kann, kann auf einen einzigen Chip vollständig integriert sein.

Bei LC-Oszillatoren wird die Frequenz durch einen Schwingkreis bestimmt. Das Oszillatorsignal wird dadurch erzeugt, daß der LC-Schwingkreis mit Hilfe eines Verstärkers entdämpft wird. Ein Verstärker verstärkt eine Eingangsspannung und es tritt dabei eine Phasenverschiebung zwischen Eingangsspannung und Ausgangsspannung auf. Am Verstärkerausgang ist ein frequenzabhängiges Rückkopplungsnetzwerk angeschlossen, das einen Schwingkreis aufweist.

Bisher wurden Oszillatoren, die die gewünschte hohe Güte im Schwingkreis erzielen und so die Anforderungen an das Phasenrauschen einhalten diskret aufgebaut oder der Schwingkreis extern als Keramik- oder Stripline-Resonator ausgeführt. Eine vollständige Integration des Oszillators auf einem Chip war dadurch jedoch nicht möglich.

Bei vollintegrierten Schaltungen wurden Differenzverstärker mit LC-Schwingkreisen ohne gekoppelte Spulen im Rückkopplungspfad verwendet, wobei die gewünschten Anforderungen an das Phasenrauschen jedoch nicht erreichbar sind.

In der DE 1 267 728 B ist ein durchstimmbarer Oszillator gezeigt, der einen Differenzverstärker enthält, dessen Eingangs- und Ausgangskreise über jeweilige Induktivitäten miteinander gekoppelt sind. Der Differenzverstärker umfaßt emittergekoppelte pnp-Transistoren. Eine weitere Kopplungswicklung bildet den Oszillatorausgang.

In der Literaturstelle March, Ian: "A Wide Range VCO", New Electronics, Band 15, Nr. 24, Dezember 1982, Seite 19 ist ein VCO mit einem Differenzverstärker gezeigt, dessen Eingangs- und Ausgangskreise über Induktivitäten miteinander gekoppelt sind. Der Differenzverstärker umfaßt an ihren Hauptstrompfaden gekoppelte MOS-Transistoren. Darüber hinaus sind die Hauptstrompfade der Transistoren über variable Kapazitäten miteinander verbunden, an denen eine Steuerspannung ansetzt.

In der Literaturstelle Nguyen N.M. et al.: "A 1.8-GHz Monolithic LC Voltage-Controlled Oscillator", IEEE Journal of Solid-State Circuits, Band 27, Nr. 3, März 1992, Seiten 444 bis 450 ist ein spannungssteuerbarer Oszillator in Colpitts-Konfiguration beschrieben. Ein erster emittergekoppelte Bipolartransistoren enthaltender Differenzverstärker umfaßt kollektorseitig je einen weiteren Differenzverstärker, die kreuzgekoppelt sind und lastseitig Resonanzkreise enthalten.

Eine Aufgabe der Erfindung ist es, einen Oszillator anzugeben, dessen Phasenrauschen möglichst gering ist.

Vorteilhafterweise ist der Oszillator auf einem Chip vollständig integrierbar.

Die Aufgabe wird durch einen Oszillator gemäß Patentanspruch 1 gelöst.

So weist der erfindungsgemäße Oszillator einen ersten Differenzverstärker und gekoppelte Induktivitäten auf. Die Eingänge und die Ausgänge des Differenzverstärkers sind mit den Induktivitäten verbunden. Die Induktivitäten sind im Rückkopplungszweig des Oszillators vorgesehen.

Vorteilhafte Weiterbildungen ergeben sich aus den abhängigen Patentansprüchen.

Eine erste Ausführungsform der Erfindung weist eine erste und eine zweite in Reihe geschaltete Induktivität sowie eine dritte und eine vierte in Reihe geschaltete Induktivität auf, wobei die erste und die dritte sowie die zweite und die vierte Induktivität miteinander gekoppelt sind. Die Eingänge des ersten Differenzverstärkers sind mit der dritten und der vierten Induktivität verbunden und die Ausgänge des ersten Differenzverstärkers sind mit der ersten und der zweiten Induktivität verbunden. Zusätzlich ist ein Potential vorgesehen, das zwischen der dritten und der vierten Induktivität anliegt.

Bei einer zweiten Ausführungsform der Erfindung sind vier in Reihe geschaltete Induktivitäten vorgesehen, wobei die erste und die zweite sowie die dritte und die vierte Induktivität gekoppelt sind. Die Ausgänge des ersten Differenzverstärkers sind mit der ersten und der vierten Induktivität und die Eingänge des ersten Differenzverstärkers sind mit den vier Induktivitäten verbunden.

Vorteilhafter Weise weist der erste Differenzverstärker einen ersten und einen zweiten Transistor auf. Die beiden Transistoren sind emittergekoppelt. Alternativ hierzu kann der erste Differenzverstärker auch einen ersten und einen zweiten Feldeffekttransistor aufweisen, welche sourcegekoppelt sind.

Um ein galvanisch entkoppeltes Oszillatorsignal zu erzeugen, weist der Oszillator eine fünfte und eine sechste in Reihe geschaltete Induktivität auf, welche mit der ersten und der zweiten Induktivität gekoppelt sind. Es ist ein zweiter Differenzverstärker vorgesehen, dessen Eingänge mit der fünften und der sechsten Induktivität verbunden sind und an dessen Ausgängen ein galvanisch entkoppeltes Oszillatorsignal anliegt.

Vorteilhafterweise weist der erfindungsgemäße Oszillator eine erste und eine zweite in Reihe geschaltete Kapazität auf, welche zwischen die Eingänge des ersten Differenzverstärkers geschaltet sind. Alternativ hierzu kann auch eine erste und eine zweite in Reihe geschaltete Kapazität zwischen den Ausgängen des ersten Differenzverstärkers geschaltet sein.

Zusätzlich kann der Oszillator eine dritte und eine vierte Kapazität aufweisen, welche in Reihe zur ersten und zweiten Kapazität geschaltet sind und bezüglich ihrer Kapazität einstellbar sind.

Die dritte und die vierte Kapazität können beispielsweise Varaktordioden sein. Es können auch die erste und die zweite Kapazität durch Varaktoren realisiert sein, falls die dritte und vierte Kapazität nicht vorhanden sind.

Um die Kapazitäten der Varaktordioden einzustellen ist zwischen den Varaktordioden ein zweites Potential vorgesehen.

Im folgenden wird die Erfindung anhand zweier Figuren weiter erläutert.
- Figur 1: zeigt eine erste Ausführungsform des erfindungsgemäßen Oszillators.
- Figur 2: zeigt eine zweite Ausführungsform des erfindungsgemäßen Oszillators.

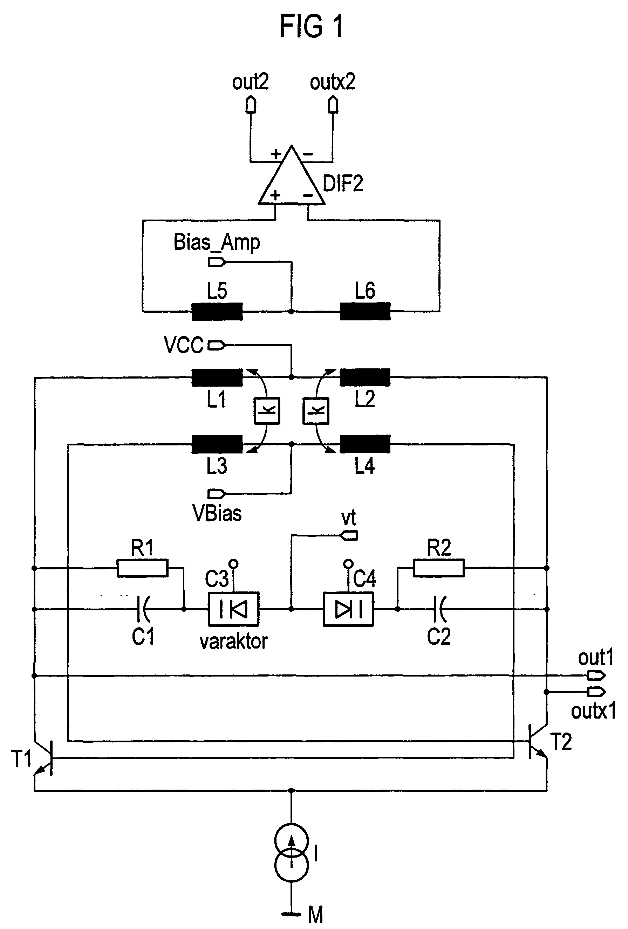

In der vollsymmetrischen Schaltung gemäß Figur 1 ist ein Differenzverstärker gezeigt, dessen Ein- und Ausgänge mit gekoppelten Induktivitäten verbunden sind. Der Differenzverstärker weist einen ersten Transistor T1 und einen zweiten Transistor T2 auf, die emittergekoppelt sind. Über die mit den Emitteranschlüssen der Transistoren T1 und T2 verbundene Stromquelle wird ein Strom I eingeprägt. Die Stromquelle I ist zusätzlich mit einem Bezugspotential M verbunden. Während der Kollektor des ersten Transistors T1 einerseits mit dem Ausgang out1 und einer ersten Induktivität L1 verbunden ist, ist der Kollektor des zweiten Transistors T2 mit dem Ausgang outx1 und einer zweiten Induktivität L2 verbunden. Die beiden Induktivitäten L1 und L2 wiederum sind in Reihe geschaltet. Die Basis des zweiten Transistors T2 führt auf eine dritte Induktivität L3 und die Basis des ersten Transistors T1 auf eine vierte Induktivität L4. Die beiden Induktivitäten L3 und L4 sind in Reihe geschaltet. Zusätzlich sind die beiden Induktivitäten L1 und L3 bzw. L2 und L4 miteinander mit einem Kopplungsfaktor k gekoppelt. Zwischen der ersten und der zweiten Induktivität L1 und L2 ist ein Versorgungspotential VCC angeklemmt. Zwischen der dritten und der vierten Induktivität L3 und L4 ist ein Biaspotential VBIAS angelegt, wodurch die Amplitude der Basis/Kollektor-Spannung an den beiden Transistoren T1 und T2 einstellbar ist. Dadurch ist das von der Energie im Schwingkreis abhängige Rauschverhalten einstellbar. Die Induktivitäten L1 und L2 sind über eine Kapazität C7 mit dem Bezugspotential M verbunden. Ebenso sind die Induktivitäten L3 und L4 über eine Kapazität C8 mit dem Bezugspotential M verbunden. Zusätzlich sind den beiden Induktivitäten L1 und L2 vier in Reihe geschaltete Kapazitäten C1, C2, C3 und C4 parallel geschaltet. Die beiden Induktivitäten L1 und L2 sowie die vier Kondensatoren C1, C2, C3 und C4 bilden damit den Parallelschwingkreis im Rückkopplungspfad des Oszillators. Dem ersten Kondensator C1 ist ein Widerstand R1 und dem zweiten Kondensator C2 ein Widerstand R2 parallel geschaltet. Die beiden Widerstände R1 und R2 dienen dazu, daß die Kondensatoren C1, C2, C3 und C4 auf definierten Potentialen liegen. Ein Potential Vt liegt zwischen den Kondensatoren C3 und C4 an. Die Kapazitäten C3 und C4 sind in Form von Varaktordioden realisiert. Durch das Potential Vt wird die Kapazität der Varaktordioden und damit der Tuning-Bereich eingestellt.

Die Transistorbasen der Transistoren T1 und T2 sind wie bei einem Multivibrator kreuzgekoppelt, jedoch nicht direkt, sondern induktiv über die gekoppelten Spulen. Die Einstellung des Potentials VT an den Kathoden der Varaktoren erfolgt durch die Widerstände R1 und R2, die parallel zu den Koppelkapazitäten C1 und C2 liegen. Somit wird ein Gleichspannungspfad zum Versorgungspotential VCC hergestellt. Die Koppelkapazitäten C1 und C2 sind erforderlich, um bei gegebener Schwingungsamplitude an den Kollektoren der Transistoren T1 und T2 den Spannungsabfall über die Varaktoren einstellen zu können. Damit wird verhindert, daß die Varaktoren zeitweise in Flußrichtung betrieben werden.

Das Biasing der Differenzverstärkertransistoren T1 und T2 erfolgt über die Induktivitäten L3 und L4. Somit kann sowohl das Versorgungspotential VCC als auch das Biaspotential VBIAS an den Basen der Transistoren T1 und T2 an einem Punkt im Schwingkreis zugeführt werden, der wechselspannungsmäßig auf dem Massepotential M liegt. Dies führt dazu, daß das Rauschen minimiert wird, da hier die Rauschbeiträge aus den Biaspotentialen über externe Kapazitäten C7 und C8 abgeblockt werden können.

Um ein galvanisch entkoppeltes Ausgangssignal des Oszillatorsignals zu erhalten, sind zwei weitere Induktivitäten L5 und L6 vorgesehen, die in Reihe zwischen die Eingänge eines Differenzverstärkers DIF2 geschaltet sind. Die fünfte Induktivität L5 ist mit der ersten Induktivität L1 oder der dritten Induktivität L3 gekoppelt, wo hingegen die sechste Induktivität L6 mit der zweiten Induktivität L2 oder der vierten Induktivität L4 gekoppelt ist. Zwischen den beiden Induktivitäten L5 und L6 ist ein weiteres Potential BIAS-Amp gelegt. An den Ausgängen out2 und outx2, welche mit dem nicht invertierenden bzw. invertierenden Ausgang des Differenzverstärkers DIF2 verbunden sind, ist das galvanisch entkoppelte Oszillatorsignal abgreifbar.

Es besteht auch die Möglichkeit, welche jedoch nicht in Figur 1 gezeigt ist, die in Reihe angeordneten Kapazitäten C1, C2, C3 und C4 nicht parallel zu den Induktivitäten L1 und L2, sondern parallel zu den Induktivitäten L3 und L4 zu schalten. Bei der in Figur 1 gezeigten Variante wird erreicht, daß über die Kollektoren der Transistoren T1 und T2 ein höherer Strom fließt als über die Basen der Transistoren T1 und T2.

Weiterhin besteht die Möglichkeit das Oszillatorsignal nicht wie in Figur 1 gezeigt an den Kollektoren der Transistoren T1 und T2, sondern an deren Basisanschlüssen abzugreifen. Eine höhere Signalamplitude wird jedoch bei dem in Figur 1 gezeigten Oszillatorsignalabgriff erreicht.

Als Varaktor können die Basisemitter-Dioden mehrerer Transistoren dienen. Es besteht auch die Möglichkeit die Basis/Kollektor-Dioden mehrerer Transistoren zu verwenden. Dies ist jedoch keine abschließende Aufzählung der möglichen Varaktorausführungen, sondern stellt lediglich Varaktorausführungsbeispiele dar. Grundsätzlich ist jede bekannte Varaktorform verwendbar.

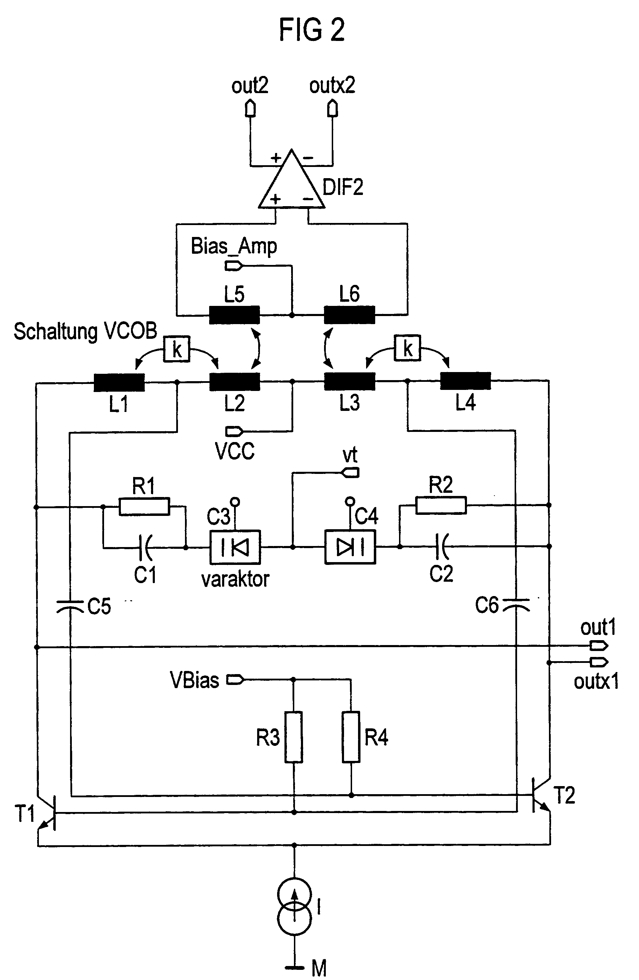

In Figur 2 ist eine weitere Ausführungsform des erfindungsgemäßen Oszillators dargestellt. Ebenso wie in Figur 1 weist der Oszillator einen Differenzverstärker mit zwei Transistoren T1 und T2 sowie einer Stromquelle auf, die einen Strom I einprägt. Die beiden Transistoren T1 und T2 sind emittergekoppelt und über die Stromquelle, die den eingeprägten Strom I liefert, mit dem Bezugspotential M verbunden. Der Kollektor des ersten Transistors T1 ist mit der ersten Induktivität L1, die Basis des zweiten Transistors T2 über einen fünften Kondensator C5 mit der ersten und der zweiten Induktivität L1 und L2, die Basis des ersten Transistors T1 über einen sechsten Kondensator mit der dritten und der vierten Induktivität L3 und L4 und der Kollektor des zweiten Transistors T2 mit der vierten Induktivität L4 verbunden. Das Oszillatorausgangssignal ist an den Klemmen outx1 und out1, welche mit den Kollektoren der Transistoren T2 bzw. T1 verbunden sind, abgreifbar. Die Induktivitäten L1, L2, L3 und L4 sind in Reihe geschaltet. Die ersten beiden Induktivitäten L1 und L2 sowie die zweiten beiden Induktivitäten L3 und L4 sind mit dem Kopplungsfaktor k gekoppelt. Die Basis des zweiten Transistors T2 ist über eine fünfte Kapazität C5 mit L1 und L2 verbunden. Zwischen den beiden Induktivitäten L2 und L3 liegt das Versorgungspotential VCC an. Parallel zu den vier in Reihe geschalteten Induktivitäten L1, L2, L3 und L4 sind die Kapazitäten C1, C2, C3 und C4 geschaltet. Damit bilden die vier Induktivitäten L1, L2, L3 und L4 mit den Kapazitäten C1, C2, C3 und C4 den Parallelschwingkreis.

Die Kapazitäten C1 und C2 können auch weggelassen werden, was eine geringere Signalamplitude zur Folge hat.

Die Kapazitäten C3 und C4 werden durch Varaktordioden gebildet. Den Kapazitäten C1 und C2 sind der Widerstand R1 bzw. der Widerstand R2 parallel geschaltet. Zwischen den Kapazitäten C3 und C4 liegt das Potential Vt an. Der Basisanschluß des Transistors T1 ist über einen Widerstand R3 und der Basisanschluß des Transistors T2 über einen Widerstand R4 mit dem Potential VBias verbunden.

In Figur 2 wird ebenfalls wie in Figur 1 ein Differenzverstärker mit kreuzgekoppelter Rückkopplung verwendet. Die Induktivitäten L1, L2, L3 und L4 können in Form einer Spule mit fünf Anschlüssen realisiert sein. Die Rückkopplung erfolgt über die Koppelkapazitäten C5 und C6. Das Biasing der Transistoren T1 und T2 erfolgt an den Basisanschlüssen der Transistoren T1 und T2 über die Widerstände R3 und R4.

Um ein galvanisch entkoppeltes Oszillatorsignal zu erhalten, sind die zwei weiteren Induktivitäten L5 und L6 mit den Induktivitäten L2 oder L1 bzw. L3 oder L4 gekoppelt. Die beiden Induktivitäten L5 und L6 sind in Reihe geschaltet und mit den Eingängen des zweiten Differenzverstärkers DIF2 verbunden. Der nichtinvertierende Ausgang des zweiten Differenzverstärkers DIF2 ist mit dem Ausgang out2 und der invertierende Ausgang des zweiten Differenzverstärkers DIF2 mit dem Ausgang outx2 verbunden. An den Ausgängen outx2 und out2 ist das galvanisch entkoppelte Oszillatorsignal abgreifbar. Zwischen den Induktivitäten L5 und L6 liegt das Potential Bias-Amp.

Zusätzlich besteht die Möglichkeit, welche jedoch nicht in Figur 2 gezeigt ist, die in Reihe angeordneten Kapazitäten C1, C2, C3 und C4 nicht parallel zu den Induktivitäten L1, L2, L3 und L4, sondern parallel zu den Induktivitäten L2 und L3 zu schalten. Bei der in Figur 2 gezeigten Variante wird erreicht, daß über die Kollektoren der Transistoren T1 und T2 ein höherer Strom fließt als über die Basen der Transistoren T1 und T2.

Weiterhin besteht die Möglichkeit das Oszillatorsignal nicht wie in Figur 2 gezeigt an den Kollektoren der Transistoren T1 und T2, sondern an deren Basisanschlüssen abzugreifen. Eine höhere Signalamplitude wird jedoch bei dem in Figur 2 gezeigten Oszillatorsignalabgriff erreicht.

Als Varaktor können die Basisemitter-Dioden mehrerer Transistoren dienen. Es besteht auch die Möglichkeit die Basis/Kollektor-Dioden mehrerer Transistoren zu verwenden. Dies ist jedoch keine abschließende Aufzählung der möglichen Varaktorausführungen, sondern stellt lediglich Varaktorausführungsbeispiele dar. Grundsätzlich ist jede bekannte Varaktorform verwendbar.

## Patentansprüche

1. Oszillator,
bei dem ein erster Differenzverstärker (T1, T2) vorgesehen ist,
bei dem eine erste, zweite, dritte und vierte Induktivität (L1, L2, L3, L4) vorgesehen sind, von denen je zwei Induktivitäten miteinander gekoppelt sind,
bei dem die Eingänge und die Ausgänge (out1, outx1) des ersten Differenzverstärkers (T1, T2) mit den Induktivitäten (L1, L2, L3, L4) verbunden sind,
bei dem die gekoppelten Induktivitäten (L1, L2, L3, L4) im Rückkopplungszweig des Oszillators vorgesehen sind,
bei dem eine fünfte und eine sechste in Reihe geschaltete Induktivität (L5, L6) vorgesehen sind, welche mit je einer der mit den genannten Ausgängen verbundenen Induktivitäten (L₁, L₂, L₃, L₄) oder mit je einer der mit den genannten Eingängen verbundenen Induktivitäten (L₁, L₂, L₃, L₄) gekoppelt sind, und
bei dem ein zweiter Differenzverstärker (DIF2) vorgesehen ist, dessen Eingänge mit der fünften und der sechsten Induktivität (L5, L6) verbunden sind und an dessen Ausgängen (out2, outx2) ein galvanisch entkoppeltes Oszillatorsignal anliegt.

2. Oszillator nach Anspruch 1,
bei dem die erste und die zweite Induktivität (L1, L2) in Reihe geschaltet sind,
bei dem die dritte und die vierte Induktivität (L3, L4) in Reihe geschaltet sind,
bei dem die erste und die dritte sowie die zweite und die vierte Induktivität miteinander gekoppelt sind,
bei dem die Eingänge des ersten Differenzverstärkers (T1, T2) mit der dritten und der vierten Induktivität (L3, L4) verbunden sind,
bei dem die Ausgänge des ersten Differenzverstärkers (T1, T2) mit der ersten und der zweiten Induktivität (L1, L2) verbunden sind, und
bei dem ein erstes Potential (VBias) vorgesehen ist, das zwischen der dritten und der vierten Induktivität (L3, L4) anliegt.

3. Oszillator nach Anspruch 1,
bei dem die erste, zweite, dritte und vierte Induktivität (L1, L2, L3, L4) in Reihe geschaltet sind,
bei dem die erste und die zweite sowie die dritte und die vierte Induktivität gekoppelt sind,
bei dem die Ausgänge (out1, outx1) des ersten Differenzverstärkers (T1, T2) mit der ersten und der vierten Induktivität (L3, L4) und die Eingänge des ersten Differenzverstärkers (T1, T2) mit den vier Induktivitäten (L1, L2, L3, L4) verbunden sind.

4. Oszillator nach einem der Ansprüche 1 bis 3,
bei dem der erste Differenzverstärker (T1, T2) einen ersten und einen zweiten Transistor aufweist, welche emittergekoppelt sind.

5. Oszillator nach einem der Ansprüche 1 bis 3,
bei dem der erste Differenzverstärker (T1, T2) einen ersten und einen zweiten Feldeffekttransistor aufweist, welche sourcegekoppelt sind.

6. Oszillator nach einem der Ansprüche 1 bis 5,
bei dem eine erste und eine zweite in Reihe geschaltete Kapazität (C1, C2) vorgesehen sind, welche zwischen die Eingänge des ersten Differenzverstärkers (T1, T2) geschaltet sind.

7. Oszillator nach einem der Ansprüche 1 bis 5,
bei dem eine erste und eine zweite in Reihe geschaltete Kapazität (C1, C2) vorgesehen sind, welche zwischen die Ausgänge des ersten Differenzverstärkers (T1, T2) geschaltet sind.

8. Oszillator nach Anspruch 7,
bei dem eine dritte und eine vierte Kapazität (C3, C4) vorgesehen sind, welche in Reihe zur ersten und zweiten Kapazität (C1, C2) geschaltet sind.

9. Oszillator nach Anspruch 8,
bei dem die dritte und die vierte Kapazität (C3, C4) Varaktordioden sind.

10. Oszillator nach Anspruch 9,
bei dem ein zweites Potential (vt) vorgesehen ist, welches zwischen den Varaktordioden anliegt, um die Kapazitäten der Varaktordioden einzustellen.

11. Oszillator nach einem der Ansprüche 1 bis 10,
bei dem die Schaltungselemente auf einem Chip integriert sind.

## Claims

1. Oscillator,
in which a first differential amplifier (T1, T2) is provided,
in which a first, a second, a third and a fourth inductance (L1, L2, L3, L4) are provided, of which two respective inductances are coupled to one another,
in which the inputs and the outputs (out1, outx1) of the first differential amplifier (T1, T2) are connected to the inductances (L1, L2, L3, L4),
in which the coupled inductances (L1, L2, L3, L4) are provided in the feedback path of the oscillator,
in which a fifth and a sixth series-connected inductance (L5, L6) are provided which are coupled to a respective one of the inductances (L1, L2, L3, L4) connected to the aforementioned outputs, or to a respective one of the inductances (L1, L2, L3, L4) connected to the aforementioned inputs, and
in which a second differential amplifier (DIF2) is provided, whose inputs are connected to the fifth and sixth inductances (L5, L6) and whose outputs (out2, outx2) produce a DC-decoupled oscillator signal.

2. Oscillator according to Claim 1,
in which the first and second inductances (L1, L2) are connected in series,
in which the third and fourth inductances (L3, L4) are connected in series,
in which the first and third and also the second and fourth inductances are coupled to one another,
in which the inputs of the first differential amplifier (T1, T2) are connected to the third and fourth inductances (L3, L4),
in which the outputs of the first differential amplifier (T1, T2) are connected to the first and second inductances (L1, L2), and
in which a first potential (VBias) is provided, which is applied between the third and fourth inductances (L3, L4).

3. Oscillator according to Claim 1,
in which the first, second, third and fourth inductances (L1, L2, L3, L4) are connected in series,
in which the first and second and also the third and fourth inductances are coupled,
in which the outputs (out1, outx1) of the first differential amplifier (T1, T2) are connected to the first and fourth inductances (L1, L4), and the inputs of the first differential amplifier (T1, T2) are connected to the four inductances (L1, L2, L3, L4).

4. Oscillator according to one of Claims 1 to 3,
in which the first differential amplifier (T1, T2) has a first and a second transistor, which are emitter-coupled.

5. Oscillator according to one of Claims 1 to 3,
in which the first differential amplifier (T1, T2) has a first and a second field-effect transistor, which are source-coupled.

6. Oscillator according to one of Claims 1 to 5,
in which a first and a second series-connected capacitance (C1, C2) are provided, which are connected between the inputs of the first differential amplifier (T1, T2).

7. Oscillator according to one of Claims 1 to 5,
in which a first and a second series-connected capacitance (C1, C2) are provided, which are connected between the outputs of the first differential amplifier (T1, T2).

8. Oscillator according to Claim 7,
in which a third and a fourth capacitance (C3, C4) are provided, which are connected in series with the first and second capacitances (C1, C2).

9. Oscillator according to Claim 8,
in which the third and fourth capacitances. (C3, C4) are varactor diodes.

10. Oscillator according to Claim 9,
in which a second potential (vt) is provided, which is applied between the varactor diodes in order to set the capacitances of the varactor diodes.

11. Oscillator according to one of Claims 1 to 10,
in which the circuit elements are integrated on a chip.

## Revendications

1. Oscillateur,
dans lequel il est prévu un premier amplificateur (T1, T2) différentiel,
dans lequel il est prévu une première, deuxième, troisième et quatrième inductance (L1, L2, L3, L4), deux inductances étant respectivement couplées entre elles,
dans lequel les entrées et les sorties (out1, outx1) du premier amplificateur (T1, T2) différentiel sont reliées aux inductances (L1, L2, L3, L4),
dans lequel les inductances (L1, L2, L3, L4) couplées sont prévues dans la branche de rétroaction de l'oscillateur,
dans lequel il est prévu une cinquième et une sixième inductance (L5, L6) montées en série, qui sont couplées à respectivement l'une des inductances (L1, L2, L3, L4) reliées auxdites sorties ou à respectivement l'une des inductances (L1, L2, L3, L4) reliées auxdites entrées et dans lequel il est prévu un deuxième amplificateur (DIF2) différentiel dont les entrées sont reliées aux cinquième et sixième inductances (L5, L6) et aux sorties (out2, outx2) duquel s'applique un signal d'oscillateur découplé galvaniquement.

2. Oscillateur suivant la revendication 1,
dans lequel la première et la deuxième inductance (L1, L2) sont montées en série,
dans lequel la troisième et la quatrième inductance (L3, L4) sont montées en série,
dans lequel la première et la troisième ainsi que la deuxième et la quatrième inductance sont couplées entre elles,
dans lequel les entrées du premier amplificateur (T1, T2) différentiel sont reliées à la troisième et à la quatrième inductance (L3, L4),
dans lequel les sorties du premier amplificateur (T1, T2) différentiel sont reliées à la première et à la deuxième inductance (L1, L2),
dans lequel il est prévu un premier potentiel (VBias) qui s'applique entre la troisième et la quatrième inductance (L3, L4).

3. Oscillateur suivant la revendication 1,
dans lequel la première, la deuxième, la troisième et la quatrième inductance (L1, L2, L3, L4) sont montées en série,
dans lequel la première et la deuxième ainsi que la troisième et la quatrième inductance sont couplées,
dans lequel les sorties (out1, outx1) du premier amplificateur (T1, T2) différentiel sont reliées à la première et à la quatrième inductance (L3, L4) et les entrées du premier amplificateur (T1, T2) différentiel sont reliées aux quatre inductances (L1, L2, L3, L4).

4. Oscillateur suivant l'une des revendications 1 à 3,
dans lequel le premier amplificateur (T1, T2) différentiel comporte un premier et un deuxième émetteurs qui sont couplés par l'émetteur.

5. Oscillateur suivant l'une des revendications 1 à 3,
dans lequel le premier amplificateur (T1, T2) différentiel comporte un premier et un deuxième transistor à effet de champ qui sont couplés par la source.

6. Oscillateur suivant l'une des revendications 1 à 5,
dans lequel il est prévu un premier et un deuxième condensateur (C1, C2) montés en série, qui sont montés entre les entrées du premier amplificateur (T1, T2) différentiel.

7. Oscillateur suivant l'une des revendications 1 à 5,
dans lequel il est prévu un premier et un deuxième condensateur (C1, C2) montés en série, qui sont montés entre les sorties du premier amplificateur (T1, T2) différentiel.

8. Oscillateur suivant la revendication 7,
dans lequel il est prévu un troisième et un quatrième condensateur. (C3, C4) qui sont montés en série avec les premier et deuxième condensateurs (C1, C2).

9. Oscillateur suivant la revendication 8,
dans lequel le troisième et le quatrième condensateurs (C3, C4) sont des varicaps.

10. Oscillateur suivant la revendication 9,
dans lequel il est prévu un deuxième potentiel (vt) qui s'applique entre les varicaps pour régler les capacités des varicaps.

11. Oscillateur suivant l'une des revendications 1 à 10,
dans lequel les éléments du circuit sont intégrés à une puce.
